# EUROPÄISCHE PATENTSCHRIFT

(11) **EP 0 842 543 B1**
(45) Veröffentlichungstag und Bekanntmachung des Hinweises auf die Patenterteilung: **13.02.2002**
(21) Anmeldenummer: 96923865.8
(22) Anmeldetag: 18.07.1996
(51) Int. Cl.: H01L 31/0232, H01L 33/00

(54) **OPTOELEKTRONISCHER WANDLER UND HERSTELLVERFAHREN**
OPTOELECTRONIC TRANSDUCER AND MANUFACTURING PROCESS
TRANSDUCTEUR OPTOELECTRONIQUE ET SON PROCEDE DE FABRICATION

(30) Priorität: 24.07.1995 DE 19527026
(43) Veröffentlichungstag der Anmeldung: 20.05.1998
(73) Patentinhaber: Infineon Technologies AG, 81669 München (DE)
(72) Erfinder: SPÄTH, Werner, D-83607 Holzkirchen (DE)
(74) Vertreter: Zedlitz, Peter, Dipl.-Inf.
(86) Internationale Anmeldenummer: DE9601316
(87) Internationale Veröffentlichungsnummer: WO9704491

(56) Entgegenhaltungen:
- EP-A- 0 412 184
- EP-A- 0 514 283
- WO-A-92/10856
- JP-A- 60 153 184
- JEE JOURNAL OF ELECTRONIC ENGINEERING, Bd. 26, Nr. 270, 26.Mai 1989, TOKYO JP, Seiten 52-54, XP000036208 YASUDA: "Infrared high-power light-emitting diodes expected to evolve to new applications"

## Beschreibung

Die Erfindung bezieht sich auf einen optoelektronischen Wandler gemäß dem Oberbegriff des Patentanspruches 1.

Ein solcher Wandler ist beispielsweise aus EP-B-412 184 bekannt und in Figur 5 dargestellt. Der Wandler nach Figur 5 ist eine Strahlungsdetektoranordnung und enthält ein Detektorbauelement 32, beispielsweise eine Fotodiode, einen gemeinsamen Träger 33, einen Isolierkörper 34, ein Befestigungsteil 35, einen Linsenträger 36 und eine Linse 37 zur Fokussierung der vom Detektorbauelement 32 empfangenen Strahlung. Das Detektorbauelement 32 ist mit seiner Unterseite auf dem Isolierkörper 34 befestigt, der wiederum auf dem gemeinsamen Träger 33 befestigt ist. Das Befestigungsteil 35 ist neben dem Isolierkörper 34 auf dem gemeinsamen Träger 33 angeordnet. Auf dem Befestigungsteil 35 ist mittels einer Befestigungsschicht 38 der Linsenträger 36 mit der Linse 37 fixiert, derart, daß sich die Linse 37 über der Strahleneintrittsfläche des Detektorelements 32 befindet.

Die Montage der einzelnen Bestandteile eines derartigen optoelektronischen Wandlers ist sehr aufwendig. Sie erfordert eine große Zahl von Verfahrensschritten und die Justage der Linse 37 ist sehr schwierig. Außerdem können aufgrund des Luftspaltes zwischen der Linse 37 und dem Detektorbauelement 32 große Reflektionsverluste auftreten.

Aus der WO-A-92/10856 ist ein optoelektronisches Bauelement bekannt, bei dem auf Bondbeulen (Bumps) eines durch Spritzgießen hergestellten optischen Elements ein photoelektrischer Chip aufliegt. Die Bondbeulen können alternativ auch an dem photoelektrischen Chip ausgebildet sein. Zwischen dem photoelektrischen Chip und dem optischen Element ist ein Spalt vorhanden, der mit einem optisch transparenten Klebstoff gefüllt ist.

In der JP-A-60-153184 ist ein lichtempfangendes Element beschrieben, bei dem ein Photoelement-Chip mit seinem elektrischen Kontakt auf seiner lichtempfangenden Seite auf einem ringförmigen Teil eines auf einem lichtdurchlässigen Substrat aufgebrachten Bond-Pads aufgebracht ist. Zwischen dem Photoelement-Chip und dem Substrat befindet sich ein Luftspalt.

Die beiden oben genannten bekannten Bauelemente weisen den Nachteil auf, daß die Reflexionsverluste am Übergang vom Chip zum optischen Element bzw. Substrat relativ groß sind.

Der Erfindung liegt die Aufgabe zugrunde, einen optoelektronischen Wandler der eingangs genannten Art so weiterzubilden, daß er sich auf einfache und kostengünstige Weise in großen Stückzahlen herstellen läßt und möglichst geringe Reflexionsverluste aufweist.

Diese Aufgabe wird durch einen optoelektronischen Wandler mit den Merkmalen des Anspruches 1 gelöst.

Weiterbildungen des erfindungsgemäßen optoelektronischen Wandlers sind Gegenstand der Unteransprüche 2 bis 9. Ein bevorzugtes Verfahren zum Herstellen des erfindungsgemäßen optoelektronischen Wandlers ist Gegenstand des Anspruches 10.

Die Erfindung wird anhand von Ausführungsbeispielen in Verbindung mit den Figuren 1a bis 4 näher erläutert. Es zeigen Figur 1a eine schematische Darstellung eines Schnittes durch ein erstes Ausführungsbeispiel eines erfindungsgemäßen optoelektronischen Wandlers,
Figur 1b eine schematische Darstellung der Draufsicht'der Trägerplatte des ersten Ausführungsbeispieles,
Figur 2 eine schematische Darstellung eines Schnittes durch ein zweites Ausführungsbeispiel eines optoelektronischen Wandlers,
Figur 3 eine schematische Darstellung eines Schnittes durch ein drittes Ausführungsbeispiel eines optoelektronischen Wandlers,
Figur 4 eine schematische Darstellung der Verfahrensschritte zur Herstellung eines optoelektronischen Wandlers gemäß dem Ausführungsbeispiel von Figur 1a oder Figur 2,
Figur 5 eine schematische Darstellung eines Schnittes durch einen optoelektronischen Wandler nach dem Stand der Technik.

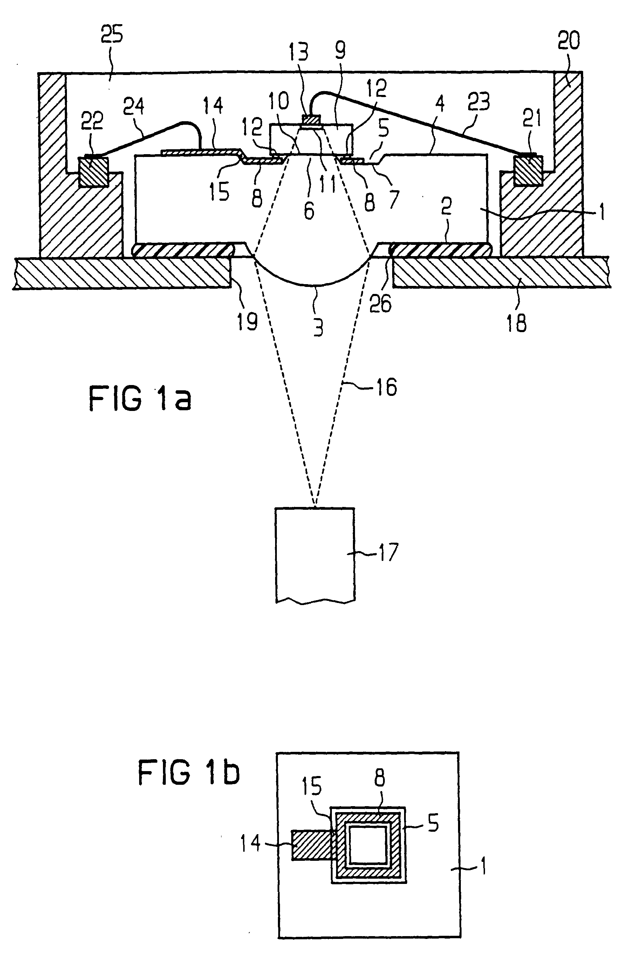

Der optoelektronische Wandler nach Figur 1a ist auf einer Trägerplatte 1 aufgebaut und enthält, ein Strahlung aussendendes und/oder empfangendes Halbleiterbauelement 9 und eine Linse 3 mit einer sphärischen oder einer asphärischen Oberfläche. Das Halbleiterbauelement 9 ist beispielsweise eine Leuchtdiode, eine Fotodiode oder ein Vertical Cavity Surface Emitter Laser (VCSEL). Die Trägerplatte 1 besteht beispielsweise aus Glas, Kunststoff, Saphir, Diamant oder aus einem Halbleitermaterial, das für die von dem Halbleiterbauelement ausgesandte bzw. empfangene Strahlung durchlässig ist. Für Wellenlängen λ > 400 nm kann beispielsweise SiC, für λ > 550 nm GaP, für λ > 900 nm GaAs und für λ > 1100 nm kann Silizium verwendet werden. Auf der Unterseite 2 der Trägerplatte 1 ist die Linse 3 ausgebildet. Auf der Oberseite 4 weist die Trägerplatte 1 eine trapezförmige Vertiefung 5 auf, die in Draufsicht (Figur 1b) auf die Oberseite 4 der Trägerplatte 1 betrachtet, die Form eines rechteckigen oder quadratischen Rahmens hat. Innerhalb dieses Rahmens ist somit eine rechteckige bzw. quadratische Insel 6 ausgebildet.

Auf der Bodenfläche 7 der Vertiefung 5 ist eine leitfähige Schicht aufgebracht, die einen leitfähigen Rahmen 8 um die Insel 6 bildet. Der leitfähige Rahmen 8 besteht beispielsweise aus Aluminium oder aus einer Aluminium-Basislegierung. Denkbar ist auch, daß im Falle der Verwendung einer Trägerplatte aus einem Halbleitermaterial in der Vertiefung 5 mittels geeigneter Dotierung ein leitfähiger Rahmen ausgebildet ist. Zur Herstellung eines derartigen durch Dotierung der Trägerplatte erzeugten leitfähigen Rahmens können die dem durchschnittlichen Fachmann heute bekannten Verfahren, wie beispielsweise Ionenimplantation, verwendet werden.

Das Halbleiterbauelement 9 weist auf seiner Oberseite eine mittige Kontaktmetallisierung 13 und auf seiner Unterseite zwei seitliche Kontaktmetallisierungen 12 auf. Die Kontaktmetallisierungen 12 sind beispielsweise mittels Löten und/oder Kleben elektrisch leitend und mechanisch stabil mit dem leitfähigen Rahmen 8 verbunden und derart ausgebildet, daß das Halbleiterbauelement mit seiner Strahlenaustrittsfläche bzw. -eintrittsfläche 10 auf der Insel 6 aufsitzt.

Die Strahlenaustrittsfläche 10 eines Strahlung aussendenden Halbleiterbauelements 9 ist die Fläche, durch die der größte Anteil der am pn-Übergang 11 des Halbleiterbauelements 9 erzeugten elektromagnetischen Strahlung aus dem Halbleiterbauelement austritt. Analog dazu ist die Strahleneintrittsfläche eines Strahlung empfangenden Halbleiterbauelements diejenige Fläche, durch die eine empfangene elektromagnetische Strahlung in das Halbleiterbauelement eintritt.

Da der leitfähige Rahmen 8 auch als Stromzuführung zum Halbleiterbauelement 9 benutzt wird, ist zum Zwecke der externen Kontaktierung auf der Oberseite der Trägerplatte 1 eine Anschlußfläche 14, beispielsweise ein Bond-Pad, aufgebracht. Die Anschlußfläche 14 ist über eine elektrisch leitende Verbindungsschicht 15 mit dem leitfähigen Rahmen 8 verbunden. Die Anschlußfläche 14 und die Verbindungsschicht 15 bestehen vorteilhafterweise aus demselben Material wie der leitfähige Rahmen 8.

Im Falle eines Strahlung aussendenden Halbleiterbauelements 9, beispielsweise einer LED, wird die im pn-Übergang 11 des Halbleiterbauelements 9 erzeugte Strahlung 16 nach Austritt aus dem Halbleiterkörper des Halbleiterbauelements 9 und Durchtritt durch die Trägerplatte 1 an der Linse 3 fokussiert. Dadurch ist gewährleistet, daß ein Großteil der im Halbleiterbauelement 9 erzeugten Strahlung beispielsweise in eine Lichtleitfaser 17 eingekoppelt werden kann.

Die Dicke der Trägerplatte 1 hängt von den Linsenparametern (z. B. Brennweite) der Linse 3 und der gewünschten Abbildung (Vergrößerung oder Verkleinerung) des Leuchtfleckes auf die Lichtleitfaser ab. Analoges gilt im Falle der Auskoppelung einer Strahlung aus einer Lichtleitfaser 17 in ein Strahlung empfangendes Halbleiterbauelement 9.

Ein bedeutender Vorteil des in Figur 1a gezeigten Ausführungsbeispieles besteht unter anderem darin, daß aufgrund des direkten Angrenzens (physikalischer Kontakt; darunter ist ein Abstand Halbleiterkörper/Trägerplatte ≤ λ/10 zu verstehen) der Strahlungsaustrittsfläche bzw. -eintrittsfläche 10 des Halbleiterbauelements 9 an die Trägerplatte 1 wesentlich geringere Reflexionsverluste auftreten als bei dem bekannten Wandler nach Figur 5. Aufgrund der stark unterschiedlichen Brechungsindizes von Luft und Halbleitermaterial ist dort nämlich für den Übergang der Strahlung von Luft ins Halbleitermaterial der Grenzwinkel der Totalreflexion vergleichsweise gering und folglich der Strahlungsverlust durch Totalreflexion sehr groß.

Der in Figur 1a gezeigte optoelektronische Wandler mit Koppeloptik ist beispielsweise in ein Gehäuse eingebaut, das aufweist, eine Grundplatte 18 mit einer Öffnung 19, eine Gehäuseseitenwand 20, externe elektrische Anschlüsse 21, 22, Anschlußdrähte 23, 24 und eine Kunststoffumhüllung 25 zur hermetischen Abdichtung des Wandlers. Anstelle der Kunststoffumhüllung 25 kann zur hermetischen Abdichtung des Gehäuses auch ein Gehäusedeckel verwendet sein, der auf der Gehäuseseitenwand 20 aufgeklebt oder -gelötet ist. Der optoelektronische Wandler ist mittels einer Befestigungs- und Abdichtschicht 26, beispielsweise bestehend aus Klebstoff und/oder Lot auf der Grundplatte 18 befestigt, derart, daß die Linse 3 über oder in der Öffnung 19 zu liegen kommt. Die Kontakmetallisierung 13 und die Anschlußfläche 14 ist mittels der Anschlußdrähte 23, 24 mit den externen elektrischen Anschlüssen 21, 22 verbunden. Die externen elektrischen Anschlüsse 21, 22 sind durch die Seitenwand 20 nach außen geführt.

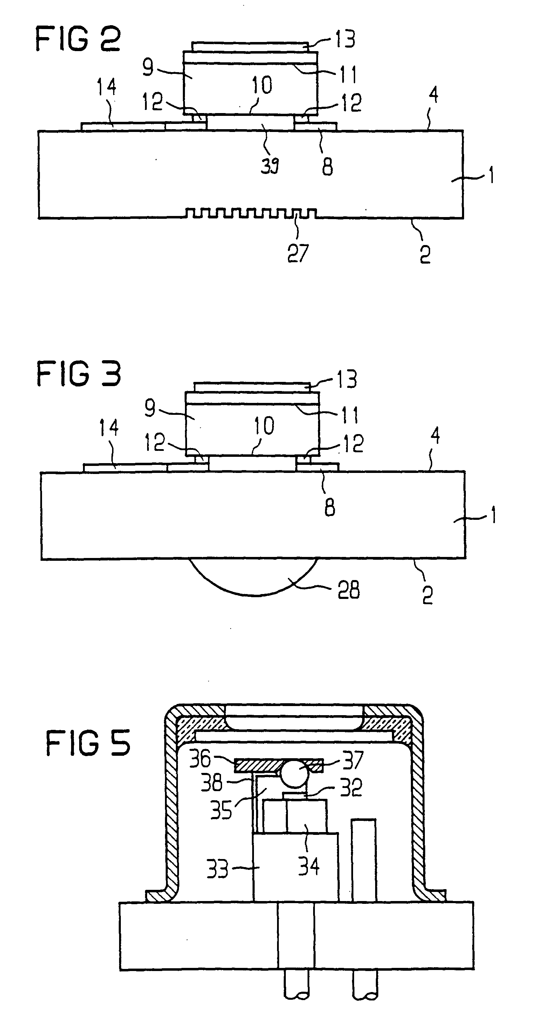

Das in Figur 2 gezeigte zweite Ausführungsbeispiel eines optoelektronischen Wandlers mit Koppeloptik ist im Prinzip identisch dem ersten Ausführungsbeispiel nach Figur 1a. Anstelle einer Linse 3 mit einer sphärischen oder asphärischen Oberfläche weist hier die Trägerplatte 1 zur Fokussierung der Strahlung ein diffraktives optisches Element 27 auf, das im weiteren kurz mit DOE bezeichnet ist. Im weiteren besitzt die Trägerplatte 1, anders als beim ersten Ausführungsbeispiel, eine ebene Oberseite 4, auf der ein leitfähiger Rahmen 8 aufgebracht ist. An den leitfähigen Rahmen 8 grenzt auf einer Seite eine elektrische Anschlußfläche 14 an. Auf dem Rahmen ist das Halbleiterbaulement 9, beispielsweise eine Leuchtdiode, eine Fotodiode oder ein Vertical Cavity Surface Emitter Laser (VCSEL), befestigt, derart, daß die Strahlenaustritts- bzw. -Eintrittsfläche und die von dem Rahmen 20 eingeschlossene Fläche übereinander angeordnet sind, und daß die Kontaktmetallisierungen 12 des Halbleiterbauelements 9 auf dem elektrisch leitenden Rahmen 8 sitzen. Die Kontaktmetallisierungen 12 sind beispielsweise mittels Lot und/oder Klebstoff elektrisch leitend und mechnisch stabil mit der Metallschicht 8 verbunden.

Bei dem in Figur 2 gezeigten Ausführungsbeispiel ist zwischen dem Halbleiterbauelement 9 und der Trägerplatte ein Luftspalt ausgebildet. Dieser Luftspalt kann, wie weiter oben bereits erwähnt, im Falle eines großen Unterschieds zwischen den Brechungsindizes von Luft und Trägerplattenmaterial erhebliche Strahlungsverluste durch Totalreflexion verursachen. Erfindungsgemäβ muß daher das Halbleiterbauelement 9 oder, wie in Figur 1a gezeigt, die Oberseite der Trägerplatte 1 derart gestaltet sein, daß die Strahlenaustrittsfläche bzw. -eintrittsfläche 10 des Halbleiterbauelements 9 auf der Trägerplatte 1 aufsitzt. Stattdessen kann auch ein geeignetes Koppelmedium 39, beispielsweise ein transparentes Gießharz (z. B. Epoxidharz), zwischen dem Halbleiterbauelement und der Trägerplatte 1 eingebracht sein.

Das in Figur 3 gezeigte dritte Ausführungsbeispiel eines optoelektronischen Wandlers unterscheidet sich von den beiden vorangehenden Ausführungsbeispielen im wesentlichen dadurch, daß das Mittel zu Fokussierung nicht in der Trägerplatte 1 ausgebildet ist, sondern daß eine vorgefertigte sphärische oder asphärische Linse 28 auf der Trägerplatte 1 befestigt ist. Anstelle der vorgefertigten Linse 28 kann in einem vierten Ausführungsbeispiel auch ein vorgefertigtes diffraktives optisches Element auf der Unterseite 2 der Trägerplatte 1 befestigt sein.

Denkbar ist auch die Verwendung eines holographischen optischen Elements oder einer Fresnellinse anstelle der sphärischen oder asphärischen Linse 28 bzw. des DOEs. Weiterhin ist auch denkbar, das Mittel zur Fokussierung der Strahlung und das Halbleiterbauelement 9 auf derselben Seite der Trägerplatte anzuordnen.

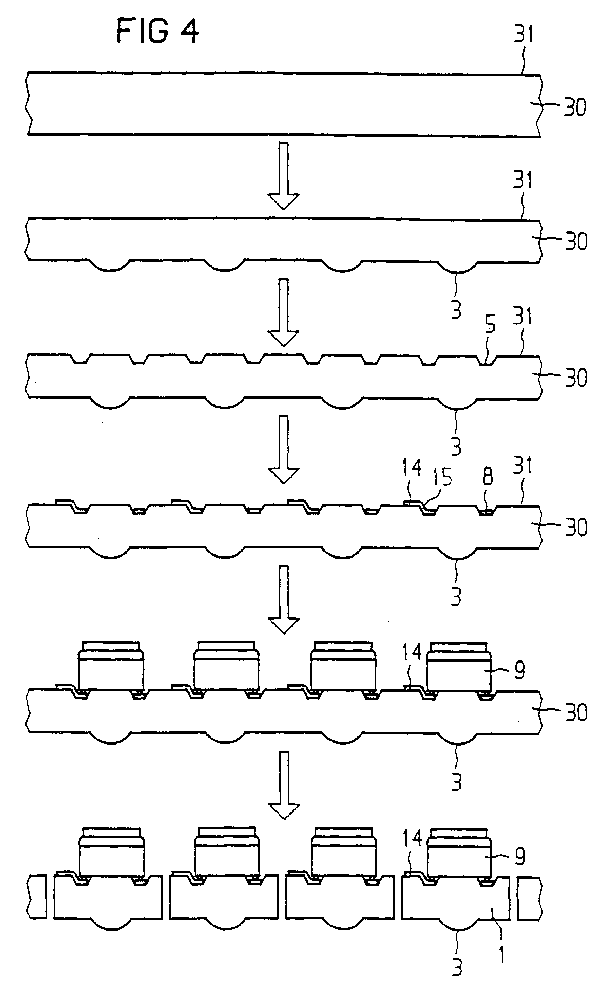

Zum gleichzeitigen Herstellen einer Mehrzahl von optoelektronischen Wandlern nach Figur 1a wird, wie in Figur 4 gezeigt, zunächst auf der Unterseite 29 einer Substratscheibe 30 entsprechend einem vorgegebenen Raster eine Mehrzahl von sphärischen oder asphärischen Linsen 3 hergestellt. Die Substratscheibe 30 ist beispielsweise aus Glas oder aus Silizium, und die Linsen 3 werden beispielsweise mittels Ätzen und/oder Schleifen hergestellt. Anschließend werden auf der Oberseite 31 der Substratscheibe 30 entsprechend dem vorgegebenen Raster beispielsweise mittels Ätzen und/oder Schleifen eine Mehrzahl von Vertiefungen 5 ausgebildet. Als nächster Schritt wird entsprechend dem vorgegebenen Raster beispielsweise mittels Aufdampfen oder Sputtern gleichzeitig eine Mehrzahl von leitfähigen Rahmen 8, eine Mehrzahl von Verbindungschichten 15 und eine Mehrzahl von Anschlußflächen 14 in die Vertiefungen 5 bzw. auf die Oberseite 31 der Substratscheibe 30 aufgebracht. Im Anschluß daran wird entsprechend dem vorgegebenen Raster eine Mehrzahl von Strahlung aussendenden und/oder empfangenden Halbleiterbauelementen befestigt. Dies erfolgt beispielsweise mittels Löten und/oder Kleben der Kontaktmetallisierungen 12 auf die leitfähigen Rahmen 8. Als nächster Schritt wird die Halbleiterscheibe beispielsweise mittels Sägen oder Ritzen und Brechen in einzelne optoelektronische Wandler vereinzelt.

Die Technik der Vereinzelung einer Substratscheibe in kleine Chips ist in der Halbleitertechnik seit langem üblich und kann bei der Vereinzelung des Verbundes aus Substratscheibe 30 und der Mehrzahl von Halbleiterbauelementen 9 und Linsen 3 ebenfalls angewandt werden. Hierbei ist es üblich, den Verbund vor dem Vereinzeln auf einer elastischen Klebefolie zu fixieren. Die Folie dient dann als Träger bei allen Nachfolgeprozessen.

Ein Verfahren zur Herstellung einer Mehrzahl von optoelektronischen Wandlern gemäß dem zweiten Ausführungsbeispiel weist im wesentlichen dieselben Schritte auf wie das oben beschriebene Verfahren. Es wird lediglich anstelle der Linsen 3 eine Mehrzahl von diffraktiven optischen Elementen 27 an der Unterseite 30 der Substratscheibe 30 ausgebildet.

Ein Verfahren zur Herstellung einer Mehrzahl von optoelektronischen Wandlern gemäß dem dritten und dem vierten Ausführungsbeispiel unterscheidet sich von den oben genannten Verfahren dadurch, daß zunächst auf der Oberseite 31 einer Substratscheibe 30 entsprechend dem vorgegebenen Raster eine Mehrzahl von leitfähigen Rahmen 8 und Anschlußflächen 14 aufgebracht wird. Anschließend wird auf die Unterseite 29 der Substratscheibe 30 entsprechend dem vorgegebenen Raster eine Mehrzahl von vorgefertigten Linsen 28 oder diffraktiven optischen Elementen beispielsweise mittels Löten und/oder Kleben aufgebracht.

Denkbar ist auch ein Verfahren, bei dem auf einer erste Substratscheibe 30 entsprechend dem vorgegebenen Raster eine Mehrzahl von leitfähigen Rahmen 8 und Anschlußflächen 14 aufgebracht wird und auf einer zweiten Substratscheibe eine Mehrzahl von Linsen 3, 28 mit sphärischer Oberfläche oder eine Mehrzahl von diffraktiven optischen Elementen 27 ausgebildet oder aufgebracht wird. Die beiden Substratscheiben werden anschließend mittels Löten und/oder Kleben miteinander verbunden, derart, daß ihre ebenen Seiten aufeinander liegen. Die weiteren Verfahrensschritte sind dieselben wie bei den oben beschriebenen Verfahren.

Bestehen die vorgefertigten Linsen 28 oder die vorgefertigten DOE bzw. die zweite Substratscheibe aus Glas und die Substratscheibe 30 bzw. die erste Substratscheibe aus Silizium oder umgekehrt, so können diese beiden Komponenten beispielsweise auch durch anodisches Bonden miteinander verbunden werden. Bei dieser bekannten Technik werden die zu verbindenden Flächen aufeinandergelegt, auf beispielsweise 450 °C aufgeheizt, und eine Spannung von etwa -1000 V an das Glas angelegt.

Von Vorteil für die oben beschriebenen Ausführungsbeispiele drei und vier ist auch, wenn die vorgefertigten Linsen 28 bzw. die vorgefertigten DOE aus einem Material bestehen, das einen ähnlichen thermischen Ausdehungskoieffizienten wie das Material der Substratscheibe 30 aufweist. Dadurch kann die Entstehung von mechanischen Spannungen bei der Herstellung sowie im Betrieb der optoelektronischen Wandler vermindert werden.

## Patentansprüche

1. Optoelektronischer Wandler, bei dem
ein Strahlung aussendendes und/oder empfangendes Halbleiterbauelement (9) auf einer Trägerplatte (1) derart befestigt ist, daß eine Strahlenaustritts- bzw. -eintrittsfläche (10) des Halbleiterbauelements (9) der Trägerplatte (1) zugewandt ist,
die Trägerplatte (1) für die ausgesandte und/oder empfangene Strahlung durchlässig ist,
ein Mittel (3, 27) zum Fokussieren einer von dem Halbleiterbauelement (9) ausgesandten bzw. empfangenen Strahlung vorgesehen ist,
die Strahlenaustritts- bzw. -eintrittsfläche (10) mit mindestens einer ersten Kontaktmetallisierung (12) versehen ist, die Trägerplatte (1) eine zweite Kontaktmetallisierung (8) aufweist und
bei dem die erste (12) und die zweite (8) Kontaktmetallisierung elektrisch leitend miteinander verbunden sind,
**dadurch gekennzeichnet,**
**daß** der Abstand zwischen der Strahlenaustritts- bzw. - eintrittsfläche (10) des Halbleiterbauelements (9) und der Trägerplatte (1) kleiner oder gleich einem Zehntel der Wellenlänge der ausgesandten bzw. empfangenen Strahlung ist.

2. Optoelektronischer Wandler nach Anspruch 1, **dadurch gekennzeichnet, daß** auf der Trägerplatte (1) eine Insel (6) ausgebildet ist, auf deren Oberfläche die Strahlenaustritts- bzw. -eintrittsfläche (10) des Halbleiterbauelements (9) aufsitzt.

3. Optoelektronischer Wandler nach Anspruch 2, **dadurch gekennzeichnet, daß** die Insel (6) von einer die zweite Kontaktmetallisierung (8) aufweisenden Vertiefung (5) umgeben ist.

4. Optoelektronischer Wandler nach einem der Ansprüche 1 bis 3, **dadurch gekennzeichnet, daß** die Trägerplatte (1) im Wesentlichen aus einem Halbleitermaterial gefertigt ist, das für die ausgesandte bzw. empfangene Strahlung durchlässig ist.

5. Optoelektronischer Wandler nach einem der Ansprüch 1 bis 4, **dadurch gekennzeichnet, daß** das Mittel (3, 27) zum Fokussieren der Strahlung einstückig mit der Trägerplatte (1) ausgebildet ist.

6. Optoelektronischer Wandler nach einem der Ansprüch 1 bis 4, **dadurch gekennzeichnet, daß** das Mittel (28) zum Fokussieren der Strahlung separat hergestellt und auf der Trägerplatte (1) aufgebracht ist.

7. Optoelektronischer Wandler nach einem der Ansprüche 1 bis 6, **dadurch gekennzeichnet, daß** das Mittel zum Fokussieren der Strahlung eine Sammellinse (3, 28) ist.

8. Optoelektronischer Wandler nach einem der Ansprüche 1 bis 6, **dadurch gekennzeichnet, daß** das Mittel zum Fokussieren der Strahlung ein diffraktives optisches Element (27) ist.

9. Optoelektronischer Wandler nach einem der Ansprüche 1 bis 8, **dadurch gekennzeichnet, daß** das Mittel (3, 27, 28) zum Fokussieren der Strahlung und das Halbleiterbauelement (9) auf gegenüberliegenden Seiten der Trägerplatte (1) angeordnet sind.

10. Verfahren zur Herstellung eines optoelektronischen Wandlers nach einem der Ansprüche 1 bis 9, **gekennzeichnet durch** die Verfahrensschritte:
a) Aufbringen einer Mehrzahl von zweiten Kontaktmetallisierungen (8) auf eine Substratscheibe (30) entsprechend einem definierten Raster;
b) Befestigen einer Mehrzahl von Halbleiterbauelementen (9) mit ersten Kontaktmetallisierungen (12) auf den zweiten Kontaktmetallisierungen (8);
c) Vereinzeln der Substratscheibe (30) entsprechend dem definierten Raster.

## Claims

1. Optoelectronic transducer, in which
a radiation-emitting and/or -receiving semiconductor component (9) is fastened on a carrier plate (1) in such a way that a beam exit and/or entry face (10) of the semiconductor component (9) is directed towards the carrier plate (1),
the carrier plate (1) is transparent to the emitted and/or received radiation,
a means (3, 27) for focusing radiation emitted and/or received by the semiconductor component (9) is provided,
the beam exit and/or entry face (10) is provided with at least one first contact metallization layer (12),
the carrier plate (1) has a second contact metallization layer (8), and
in which the first (12) and the second (8) contact metallization layer are electrically conductively connected to one another,
**characterized**
**in that** the distance between the beam exit and/or entry face (10) of the semiconductor component (9) and the carrier plate (1) is less than or equal to one tenth of the wavelength of the emitted and/or received radiation.

2. Optoelectronic transducer according to Claim 1, **characterized in that** an island (6) is formed on the carrier plate (1), and the beam exit and/or entry face (10) of the semiconductor component (9) is seated on the surface of said island.

3. Optoelectronic transducer according to Claim 2, **characterized in that** the island (6) is surrounded by a depression (5) having the second contact metallization layer (8).

4. Optoelectronic transducer according to one of Claims 1 to 3, **characterized in that** the carrier plate (1) is essentially produced from a semiconductor material which is transparent to the emitted and/or received radiation.

5. Optoelectronic transducer according to one of Claims 1 to 4, **characterized in that** the means (3, 27) for focusing the radiation is formed in one piece with the carrier plate (1).

6. Optoelectronic transducer according to one of Claims 1 to 4, **characterized in that** the means (28) for focusing the radiation is produced separately and applied to the carrier plate (1).

7. Optoelectronic transducer according to one of Claims 1 to 6, **characterized in that** the means for focusing the radiation is a converging lens (3, 28).

8. Optoelectronic transducer according to one of Claims 1 to 6, **characterized in that** the means for focusing the radiation is a diffractive optical element (27).

9. Optoelectronic transducer according to one of Claims 1 to 8, **characterized in that** the means (3, 27, 28) for focusing the radiation and the semiconductor component (9) are arranged on opposite sides of the carrier plate (1).

10. Method for the production of an optoelectronic transducer according to one of Claims 1 to 9, **characterized by** the method steps:
a) application of a plurality of second contact metallization layers (8) to a substrate wafer (30) according to a defined grid pattern;
b) fastening of a plurality of semiconductor components (9) with first contact metallization layers (12) on the second contact metallization layers (8);
c) separation of the substrate wafer (30) according to the defined grid pattern.

## Revendications

1. Transducteur optoélectronique, dans lequel un composant (9) à semi-conducteur émettant un rayonnement et/ou le recevant est fixé sur une plaque (1) support de façon qu'une surface (10) de sortie ou d'entrée de rayonnement du composant (9) à semi-conducteur soit tournée vers la plaque (1) support,
la plaque (1) support est transparente au rayonnement émis et/ou reçu,
il est prévu un moyen (3, 27) de focalisation d'un rayonnement émis ou reçu par le composant (9) à semi-conducteur,
la surface (10) de sortie ou d'entrée du rayonnement est muni d'au moins une première métallisation (12) de contact, la plaque (1) support comporte une deuxième métallisation (8) de contact, et
dans lequel la première (12) et la deuxième (8) métallisation de contact sont reliées entre elles d'une manière conductrice de l'électricité,
**caractérisé**
**en ce que** la distance entre la surface (2) de sortie ou d'entrée du rayonnement du composant (9) à semi-conducteur et la plaque (1) support est inférieure ou égale à 1/10^{ème} de la longueur d'onde du rayonnement émis ou reçu.

2. Transducteur optoélectronique suivant la revendication 1, **caractérisé en ce qu'**il est constitué sur la plaque (1) support un îlot (6) à la surface duquel s'applique la surface (10) de sortie ou d'entrée du rayonnement du composant (9) à semi-conducteur.

3. Transducteur optoélectronique suivant la revendication 2, **caractérisé en ce que** l'îlot (6) est entouré d'une cavité (5) comportant la deuxième métallisation (8) de contact.

4. Transducteur optoélectronique suivant l'une des revendications 1 à 3, **caractérisé en ce que** la plaque (1) support est fabriquée essentiellement en un matériau semi-conducteur qui est transparent au rayonnement émis ou reçu.

5. Transducteur optoélectronique suivant l'une des revendications 1 à 4, **caractérisé en ce que** le moyen (3, 27) de focalisation du rayonnement est d'un seul tenant avec la plaque (1) support.

6. Transducteur optoélectronique suivant l'une des revendications 1 à 4, **caractérisé en ce que** le moyen (28) de focalisation du rayonnement est fabriqué séparément et est appliqué sur la plaque (1) support.

7. Transducteur optoélectronique suivant l'une des revendications 1 à 6, **caractérisé en ce que** le moyen de focalisation du rayonnement est une lentille (3, 28) convexe.

8. Transducteur optoélectronique suivant l'une des revendications 1 à 6, **caractérisé en ce que** le moyen de focalisation du rayonnement est un élément (27) optique de diffraction.

9. Transducteur optoélectronique suivant l'une des revendications 1 à 8, **caractérisé en ce que** le moyen (3, 27, 28) de focalisation du rayonnement et le composant (9) à semi-conducteur sont disposés sur des faces opposées de la plaque (1) support.

10. Procédé de fabrication d'un transducteur optoélectronique suivant l'une des revendications 1 à 9, **caractérisé par** les stades de procédé :
a) dépôt d'une multiplicité de deuxièmes métallisations (8) de contact sur un disque (30) formant substrat conformément à une trame définie ;
b) fixation d'une multiplicité de composants (9) à semi-conducteurs ayant de premières métallisations (12) de contact sur les secondes métallisations (8) de contact ;
c) individualisation des disques de substrats conformément à la trame définie.
